# FASCICULE DE BREVET EUROPEEN

(11) **EP 0 576 374 B1**
(45) Date de publication et mention de la délivrance du brevet: **02.11.1995**
(21) Numéro de dépôt: 93420261.5
(22) Date de dépôt: 22.06.1993
(51) Int. Cl.: H05K 13/00, H01L 21/00

(54) **Outil de montage de puce entre deux dissipateurs thermiques**
Werkzeug zur Montage eines Chip zwischen zwei Wärmeableitern
Tool for mounting a chip between two heat sinks

(30) Priorité: 26.06.1992 FR 9208282
(43) Date de publication de la demande: 29.12.1993
(73) Titulaire: SGS-THOMSON MICROELECTRONICS S.A., 94250 Gentilly (FR)
(72) Inventeur: Pouet, Claude, F-37100 Tours (FR); Collumeau, Yoland, F-37210 Rochecorbon (FR)
(74) Mandataire: de Beaumont, Michel

(56) Documents cités:
- EP-A- 0 306 021
- EP-A- 0 306 957

## Description

La présente invention concerne les composants électroniques de puissance, notamment des puces semiconductrices brasées entre deux dissipateurs thermiques plats, généralement des disques en cuivre.

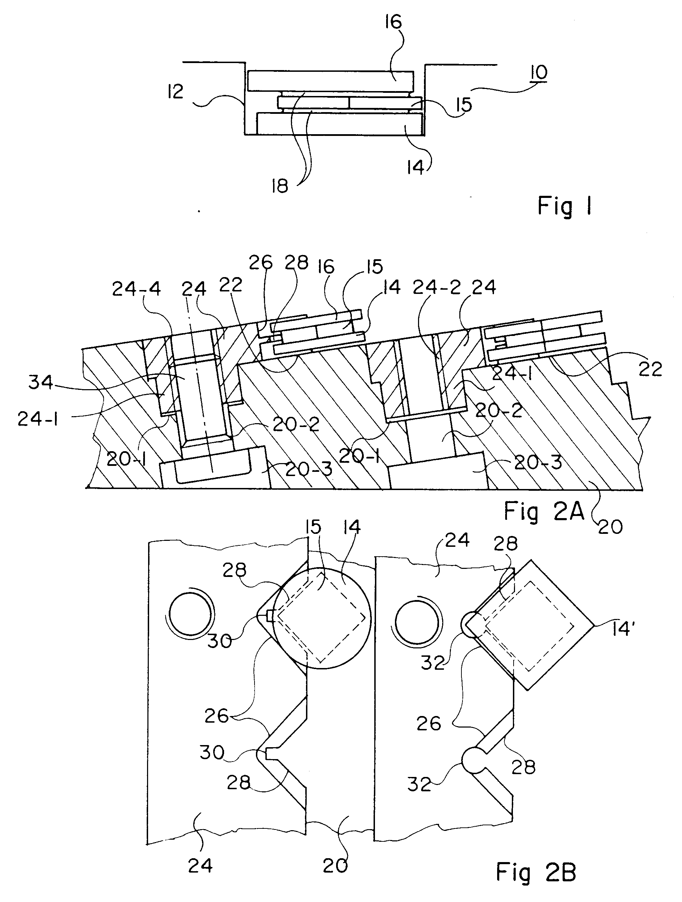

La figure 1 illustre une vue en coupe partielle simplifiée d'un outil de montage de puce entre deux dissipateurs thermiques en forme de disque. L'outil 10 comprend des alvéoles cylindriques 12 (une seule est représentée) dans lesquelles sont successivement introduits un premier disque en cuivre 14, une puce 15, généralement carrée, et un deuxième disque 16. Le diamètre des disques 14 et 16 est supérieur à une diagonale de la puce 15. La puce 15 est représentée en vue de côté selon une diagonale.

Les éléments 14 à 16 sont solidarisés les uns aux autres par de la brasure 18 disposée initialement sur les deux faces de la puce 15 et/ou sur une face des disques ou apportée sous forme de préformes.

Le diamètre de l'alvéole 12 est légèrement supérieur au diamètre des disques 14 et 16 afin de permettre une insertion et un retrait aisé de l'empilement constitué par les éléments 14 à 16. Ainsi, dans la plupart des cas, comme cela est représenté, les éléments 14 à 16 sont décalés les uns par rapport aux autres et un coin de la puce 15 (le coin droit dans la figure 1) peut déborder de l'un des dissipateurs, ce qui expose ce coin dans la suite du traitement de l'empilement à des chocs pouvant entraîner sa rupture. En outre, pour faire fondre la brasure 18, l'outil 10 muni de ses empilements est introduit dans un four sur un tapis de transport. Si les éléments 14 à 16 sont par hasard initialement bien alignés, les vibrations du tapis peuvent tendre à les décaler, cet effet de décalage étant par ailleurs facilité par la brasure 18 en fusion.

Un objet de la présente invention est de prévoir un outil permettant de positionner deux dissipateurs thermiques par rapport à une puce afin d'éviter qu'un coin de la puce déborde d'un dissipateur.

Un autre objet de la présente invention est de prévoir un tel outil sur lequel les puces et les dissipateurs peuvent être disposés de façon aisée.

Un autre objet de la présente invention est de prévoir un tel outil permettant d'utiliser des dissipateurs de forme carrée.

Ces objets sont atteints grâce à l'emploi, à la place des alvéoles susmentionnées, de vés dans lesquels les éléments des empilements viennent se positionner par gravité, une portion de vé de dimension adéquate étant associée à chaque élément de l'empilement.

Dans le cas classique d'un outil à alvéoles, il n'était pas envisageable de positionner les éléments par gravité, par exemple en inclinant l'outil 10, car deux des coins des puces seraient alors positionnés juste au niveau du bord des dissipateurs, ce qui expose également ces coins à des chocs. Selon l'invention, en disposant convenablement les portions de vé associées respectivement aux éléments des empilements, les coins de la puce seront toujours en retrait par rapport aux bords des dissipateurs.

La présente invention vise plus particulièrement un outil de montage de puces entre deux dissipateurs thermiques plats, comprenant : un socle muni d'un ensemble de rampes disposées en dent de scie ; une pluralité de vés principaux disposés en alignement au fond des rampes et ouverts vers le sommet des rampes ; et pour chaque vé principal, un vé médian faisant saillie du vé principal et séparant celui-ci en deux sous-vés destinés à recevoir chacun un dissipateur thermique parallèlement à la rampe associée, le vé médian étant destiné à recevoir une puce.

Selon un mode de réalisation de la présente invention, les vés sont réalisés dans des réglettes parallèles aux rampes, ces réglettes comprenant chacune une extension de guidage disposée dans une rainure du fond d'une rampe associée.

Selon un mode de réalisation de la présente invention, les réglettes sont fixées au socle par des vis traversant le socle et se vissant dans les réglettes.

Selon un mode de réalisation de la présente invention, les fonds des vés sont munis d'un dégagement en forme de perçage.

Ces objets, caractéristiques et avantages ainsi que d'autres de la présente invention seront exposés en détail dans la description suivante de modes de réalisation particuliers faite en relation avec les figures jointes parmi lesquelles :
la figure 1, précédemment décrite, représente une vue partielle en coupe d'un outil classique de montage de puce entre deux dissipateurs thermiques ;
les figures 2A et 2B représentent respectivement des vues partielles en coupe et de dessus d'un mode de réalisation d'outil de montage selon la présente invention ; et
la figure 2C représente une vue en perspective de l'outil des figures 2A et 2B.

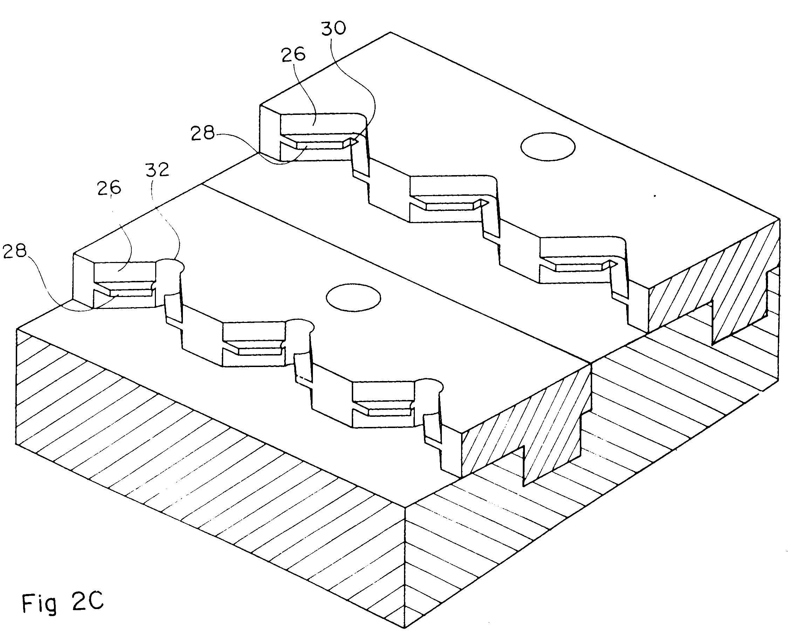

Les figures 2A à 2C seront décrites simultanément, ces diverses vues considérées ensemble permettant de mieux apercevoir la constitution de l'outil selon l'invention.

L'outil selon le mode de réalisation de l'invention représenté comprend un socle horizontal 20 de forme générale rectangulaire muni sur sa face supérieure d'un ensemble de rampes inclinées 22 disposées en dent de scie, c'est-à-dire que les rampes sont parallèles les unes aux autres et que la fin, ou sommet d'une rampe est raccordée au début, au fond d'une rampe suivante par un échelon descendant. Dans le fond de chaque rampe est disposée une réglette 24 parallèle à la rampe. Chaque réglette 24 est munie d'un ensemble de vés 26 juxtaposés parallèlement au fond de la rampe associée. Les parois formant chaque vé sont perpendiculaires entre elles et à la rampe. Les vés sont ouverts vers le sommet de la rampe, c'est-à-dire que l'intersection des parois des vés est du côté du fond de la rampe.

Chaque vé 26 est séparé en deux sous-vés par un vé médian 28 faisant saillie environ au centre du vé 26. L'épaisseur du sous-vé 26 inférieur est sensiblement égale à l'épaisseur des dissipateurs, et l'épaisseur du vé médian 28 est légèrement inférieure à l'épaisseur de la puce. L'épaisseur du sous-vé supérieur est quelconque.

Dans les figures 2A et 2B, on a représenté deux empilements formés chacun d'une puce 15 prise entre deux dissipateurs 14 et 16. Un premier des dissipateurs, 14, de chaque empilement est en appui sur une rampe 22 et dans un vé 26, en dessous du vé médian 28 correspondant. La puce 15 est en appui sur le dissipateur 14 et dans le vé médian 28. Finalement, le deuxième dissipateur 16 est en appui sur la puce 15 et dans le vé 26 au-dessus du vé médian 28. Ainsi, en choisissant convenablement les positions relatives des parois des vés 26 et 28 en fonction des dimensions des éléments 14 à 16, la puce 15 est toujours bien positionnée par rapport aux dissipateurs 14, 16 de sorte que ses coins soient toujours en retrait par rapport aux bords des dissipateurs. Bien entendu, deux vés 26 adjacents sont situés suffisamment loin l'un de l'autre pour que deux dissipateurs adjacents placés dans ces vés ne se touchent pas.

Un outil de montage selon l'invention, comme les outils de montage classiques (figure 1), est prévu pour effectuer un traitement par lots. Il comprend, par exemple, 12 réglettes 24 de 22 vés chacune. Le placement des éléments 14 à 16 dans les vés est réalisé à l'aide d'un outillage classique, tel que celui utilisé pour placer les éléments dans les alvéoles 12 de la figure 1. Il est courant d'utiliser des outillages qui fonctionnent par aspiration et qui maintiennent de manière pré-positionnée tous les éléments (14, 15 ou 16) à placer en une passe sur un outil de montage. De préférence, les premiers dissipateurs thermiques 14 sont posés sur les rampes 22 en face des vés correspondants 26, légèrement distants de ceux-ci, de manière que leur placement ne soit pas gêné par les vés 28. Les dissipateurs 14 glissent alors sur les rampes 22 par gravité et viennent dans leurs sous-vés 26 correspondants. Ce glissement pourra être facilité en appliquant des vibrations au montage. Les puces 15 sont ensuite posées sur les dissipateurs 14, également légèrement à distance des vés 28 correspondants afin que les puces, carrées, puissent être posées sur les dissipateurs 14 avec une certaine incertitude d'orientation. En effet, il se peut qu'une puce 15 soit orientée de telle sorte qu'un de ses coins vienne buter contre une face d'appui du vé médian 28. Si cela se produit, la puce 15 viendra se positionner correctement, c'est-à-dire de manière qu'un de ses coins soit dans le fond du vé 28, grâce à des vibrations que l'on fera subir au montage. Les deuxièmes dissipateurs 16 sont ensuite posés sur les puces 15, également légèrement à distance par rapport aux sous-vés 26 correspondants.

Le fait d'utiliser des vés pour positionner des dissipateurs thermiques permet d'utiliser des dissipateurs thermiques de forme carrée 14′, comme cela est représenté à la figure 2B.

L'utilisation de dissipateurs thermiques carrés présente l'avantage que, lors de la réalisation de ceux-ci, on perd moins de matière (en l'occurence du cuivre) que pour la réalisation de dissipateurs en forme de disque.

Un autre avantage de l'utilisation de dissipateurs carrés est que l'on obtient une orientation angulaire relative des dissipateurs et de la puce et que l'on peut prévoir une localisation des surfaces de contact entre la puce et les dissipateurs. Il suffit que la face du dissipateur en contact avec la puce présente des régions en surépaisseur qui seront les seules à être brasées sur la puce. Par contre, avec des dissipateurs en forme de disque, le positionnement entre eux et par rapport à la puce est assuré seulement pour le contour des dissipateurs, mais ne l'est pas pour le positionnement angulaire des dissipateurs par rapport à la puce.

L'utilisation de dissipateurs carrés n'était pas envisageable classiquement car les alvéoles 12 (figure 1) sont cylindriques (une forme carrée étant très difficile à obtenir en creux) ce qui ne permet pas d'orienter des dissipateurs carrés entre eux et par rapport à la puce. Même si l'on réalisait des alvéoles carrées, on s'exposerait au risque d'avoir au moins un coin de puce situé à la hauteur d'un bord de dissipateur, ce qui exposerait ce coin à des chocs.

Afin de prévoir un bon positionnement d'une pièce carrée dans un vé (c'est-à-dire que deux faces de la pièce carrée viennent en appui contre les parois du vé), on prévoit un dégagement au fond du vé pour les coins de la pièce. Comme cela est représenté à la figure 2B, les vés secondaires 28 de la réglette 24 de gauche comprennent chacun en leur fond une rainure de dégagement 30. Si l'on prévoit d'utiliser des dissipateurs carrés, les vés 26 sont également munis de dégagements. Selon un autre mode de réalisation, comme cela est représenté pour la réglette 24 de droite dans la figure 2B, la réglette comprend des perçages 32 dans lesquels débouchent les parois des vés 26 et 28.

Par ailleurs, chaque réglette 24 comprend une extension perpendiculaire 24-1 ajustée dans une rainure 20-1 du socle 20. Cette rainure 20-1 est perpendiculaire aux rampes 22 et située au fond de celles-ci. Ce montage a pour but d'assurer la rigidité de l'ensemble et d'éviter la déformation de la réglette dans le temps. Chaque réglette 24 comprend un nombre suffisant (par exemple 3 pour des réglettes de 22 vés) de taraudages 24-2 traversant les extensions 24-1. Ces taraudages 24-2 permettent de fixer les réglettes sur le socle 20 par l'intermédiaire de vis traversant des trous 20-2 du socle 20. Les têtes des vis sont noyées et prennent appui dans des alésages 20-3 du fond du socle 20. Les taraudages 24-2, les trous 20-2 et les alésages 20-3 sont parallèles à l'axe des rainures 20-1.

De nombreuses variantes et modifications de la présente invention apparaîtront à l'homme du métier, notamment en ce qui concerne les modes de fixation des réglettes sur le socle 20.

## Revendications

1. Outil de montage de puces (15) entre deux dissipateurs thermiques plats (14, 16), caractérisé en ce qu'il comprend :
- un socle (20) muni d'un ensemble de rampes (22) disposées en dent de scie ;
- une pluralité de vés principaux (26) disposés en alignement au fond des rampes et ouverts vers le sommet des rampes ; et
- pour chaque vé principal, un vé médian (28) faisant saillie du vé principal et séparant celui-ci en deux sous-vés destinés à recevoir chacun un dissipateur thermique parallèlement à la rampe associée, le vé médian étant destiné à recevoir une puce.

2. Outil selon la revendication 1, caractérisé en ce que les vés sont réalisés dans des réglettes (24) parallèles aux rampes, ces réglettes comprenant chacune une extension de guidage (24-1) disposée dans une rainure (20-1) du fond d'une rampe associée.

3. Outil selon la revendication 2, caractérisé en ce que les réglettes (24) sont fixées au socle (20) par des vis (34) traversant le socle et se vissant dans les réglettes.

4. Outil selon la revendication 1, caractérisé en ce que les fonds des vés sont munis d'un dégagement en forme de perçage (32).

## Patentansprüche

1. Werkzeug zur Montage von Chips (15) zwischen zwei ebenen Wärmesenken (14, 16), **gekennzeichnet,** durch:
- einen Sockel (20), der eine Rampenanordnung (22) aufweist, die in einem Sägezahn-Muster angeordnet sind,
- mehrere Haupt-Vs (26), welche fluchtend am Boden der Rampen angeordnet sind und sich in Richtung zur Oberseite der Rampen öffnen, und
- ein mittleres V (28) für jedes Haupt-V, welches von dem Haupt-V vorspringt und dieses in zwei Unter-Vs aufteilt, welche jeweils parallel zu der zugehörigen Rampe eine Wärmesenke aufnehmen können, wobei das mittlere V einen Chip aufnehmen kann.

2. Werkzeug nach Anspruch 1, dadurch **gekennzeichnet**, daß die Vs in Leisten (24) ausgebildet sind, welche parallel zu den Rampen verlaufen, wobei diese Leisten jeweils ein Führungs-Verlängerungsstück (24-1) aufweisen, das in einer Rille (20-1) am Boden einer zugehörigen Rampe verläuft.

3. Werkzeug nach Anspruch 2, dadurch **gekennzeichnet**, daß die Leisten (24) an dem Sockel (20) mittels Schrauben (34) befestigt sind, welche durch den Sockel hindurchgehen und in die Leisten einschraubbar sind.

4. Werkzeug nach Anspruch 1, dadurch **gekennzeichnet**, daß die Basis der Vs ein Aussparung in Form einer Perforierung (32) aufweisen.

## Claims

1. A device for mounting chips (15) between two flat heat sinks (14, 16), characterized in that it includes:
- a base (20) provided with an assembly of ramps (22) disposed in a saw-tooth pattern;
- a plurality of main vee-shaped stops (26) aligned at the bottom of said ramps and open in a direction toward the top of the ramps; and
- for each main vee stop, a median vee-shaped stop (28) protruding from the main stop and dividing it into two vee-shaped sub-stops, for receiving a heat sink disposed in parallel with the associated ramp, said median stop being designed to accommodate a chip.

2. The device of claim 1, characterized in that said vee-shaped stops are formed in rules (24) disposed parallel to said ramps, each rule including a guiding projection portion (24-1) disposed in a groove (20-1) provided in the bottom of an associated ramp.

3. The device of claim 1, characterized in that said rules (24) are fixed to said base (20) by means of screws (34) passing through the base and screwed in said rules.

4. The device of claim 1, characterized in that the bottoms of said vees are provided with a recess formed by piercing (32).
